# EUROPEAN PATENT SPECIFICATION

(11) **EP 4 250 429 B1**
(45) Date of publication and mention of the grant of the patent: **15.07.2026**
(21) Application number: 21904892.3
(22) Date of filing: 22.04.2021
(51) Int. Cl.: H01M 10/42, H01M 10/48, H01M 50/204, H01M 50/519, H01M 50/284

(54) **BATTERY INFORMATION SAMPLING COMPONENT, BATTERY MODULE, AND BATTERY PACK**
KOMPONENTE ZUR ABTASTUNG VON BATTERIEINFORMATIONEN, BATTERIEMODUL UND BATTERIEPACK
COMPOSANT D'ÉCHANTILLONNAGE D'INFORMATIONS DE BATTERIE, MODULE DE BATTERIE ET BLOC-BATTERIE

(30) Priority: 16.12.2020 CN 202011487832
(43) Date of publication of application: 27.09.2023
(73) Proprietor: BYD Company Limited, Shenzhen, Guangdong 518118 (CN)
(72) Inventor: WANG, Yongnan, Shenzhen, Guangdong 518118 (CN); ZENG, Yi, Shenzhen, Guangdong 518118 (CN); ZHENG, Weixin, Shenzhen, Guangdong 518118 (CN); LIAO, Zhengyuan, Shenzhen, Guangdong 518118 (CN)
(74) Representative: Dehns Germany Partnerschaft mbB
(86) International application number: PCT/CN2021/089036
(87) International publication number: WO 2022/126953

(56) References cited:
- CN-A- 111 430 650
- CN-U- 204 029 949
- CN-U- 207 884 968
- CN-U- 209 515 833
- JP-A- 2019 036 386
- KR-B1- 101 750 489
- US-A1- 2013 302 651
- US-A1- 2020 006 814
- US-A1- 2022 131 237
- NONE: "Become a master of mounting! - Design of reinforcing plates required for FPC mounting -", 28 July 2020 (2020-07-28), pages 1 - 5, XP093316240, Retrieved from the Internet <URL:https://ac-blog.panasonic.com/connector/become-a-master-of-mounting-design-of-reinforcing-plates-required-for-fpc-mounting-> [retrieved on 20250918]

## Description

### FIELD

The present invention relates to the technical field of batteries, and specifically, to a battery information sampling assembly/component, a battery module, and a battery pack.

### BACKGROUND

In response to continuous development of new energy technologies, the application of battery modules/battery packs is becoming wider. In order to ensure the normal operation of a battery, it is necessary to collect information such as a voltage and a temperature of each cell in a battery module/battery pack and monitor an operating status of each cell, to ensure a safe operation of the battery module/battery pack.

In the existing technology, the circuit board is connected with a battery sampling controller through a wire harness. The configuration of the wire harness occupies an internal space of the battery module/battery pack, which reduces the energy density of the battery module/battery pack. In addition, the wire harness is prone to contact with relevant components in the battery module/battery pack. When the battery module/battery pack is used in a vehicle, the vibration of vehicle during travelling causes the wire harness to rub against relevant metal components. Longterm vibration and friction cause damages to the wire harness, which affects the normal use and safety of the battery module/battery pack.

For example, document US 2013/302651 A1 refers to a battery pack including a plurality of battery cells, each including an electrode terminal; and a circuit board assembly including: a first circuit board electrically connecting the electrode terminals of adjacent battery cells of the plurality of battery cells; a second circuit board electrically connected to the first circuit board; and a connection wire electrically connected between the second circuit board and the first circuit board.

For example, document CN 111430650 A discloses a battery pack and a vehicle. The battery pack comprises a plurality of battery modules and an electric connection part, the plurality of battery modules are arranged in parallel, and the electric connecting part is arranged at the end parts of the plurality of battery modules and is provided with an electrode connecting end and an FPC connecting end. The electrode connecting end is suitable for being electrically connected with a plurality of poles of the plurality of battery modules respectively, and the FPC connecting end is suitable for being electrically connected with a plurality of FPCs corresponding to the plurality of battery modules.

### SUMMARY

The present invention resolves at least one of the technical problems in the related art. The present invention provides a battery information sampling assembly (battery information sampling component), a battery module, and battery pack with the features of the independent claims. The battery information sampling assembly can improve the space utilization of a battery module and has higher operation stability.

In a first aspect, a battery information sampling assembly according to claim 1 is provided.

The battery sampling controller in the battery information sampling assembly is directly connected with the flexible printed circuit board, without a need to include an additional wire harness to connect the battery sampling controller to the flexible printed circuit board, which improves the space utilization of a battery module and improves the energy density of a battery module or a battery pack. In addition, a problem of a failure of the battery information sampling assembly caused by wear of a wire harness as a result of external factors is avoided.

In a second aspect, a battery module is provided, which includes a cell and a battery support disposed on the cell, and further includes the battery information sampling assembly of the first aspect.

In a third aspect, a battery pack is provided, which includes a cell and a battery support disposed on the cell, and further includes the battery information sampling assembly of the first aspect.

Additional aspects and advantages of the present invention are provided in the following description, some of which will become apparent from the following description or may be learned from practices of the present invention.

### BRIEF DESCRIPTION OF THE DRAWINGS

The above and/or additional aspects and advantages of the present invention will become apparent and comprehensible from the description of the embodiments provided with reference to the following drawings.
FIG. 1 is a three-dimensional schematic structural diagram of a battery information sampling assembly/component according to an embodiment of the present invention.
FIG. 2 is a schematic structural cross-sectional view of the battery information sampling assembly according to an embodiment of the present invention.
FIG. 3 is a schematic structural diagram of a surface of the battery information sampling assembly according to an embodiment of the present invention.
FIG. 4 is a structural diagram of a cell and the battery information sampling assembly according to an embodiment of the present invention.
FIG. 5 is a schematic diagram of an assembly structure of the cell and the battery information sampling assembly of a battery module according to an embodiment of the present invention.
FIG. 6 is a schematic diagram of a battery pack according to an embodiment of the present invention.

### DETAILED DESCRIPTION

Embodiments of the present invention are described in detail below, and examples of the embodiments are shown in the drawings, where the same or similar elements or the elements having the same or similar functions are represented by the same or similar reference numerals throughout the description. The embodiments described below with reference to the drawings are examples and used only for explaining the present invention, and do not limit the present invention.

In the description of the present invention, it should be understood that orientation or position relationships indicated by the terms such as "center", "up", "down", "left", "right", "vertical", "horizontal", "top", "bottom", "inside", and "outside" are based on orientation or position relationships shown in the drawings, and are used only for ease and brevity of description of the present invention, rather than indicating or implying that the mentioned apparatus or element needs to have a particular orientation or needs to be included and operated in a particular orientation. Therefore, the terms do not limit the present invention as defined by the independent claims.

It should be noted that the terms "first" and "second" are merely used for description, and do not indicate or imply relative importance or implicitly indicate a number of technical features that are indicated. Therefore, features defined by "first" and "second" may explicitly or implicitly include one or more such features. Further, in the description of the present invention, unless otherwise stated, "multiple" means two or more.

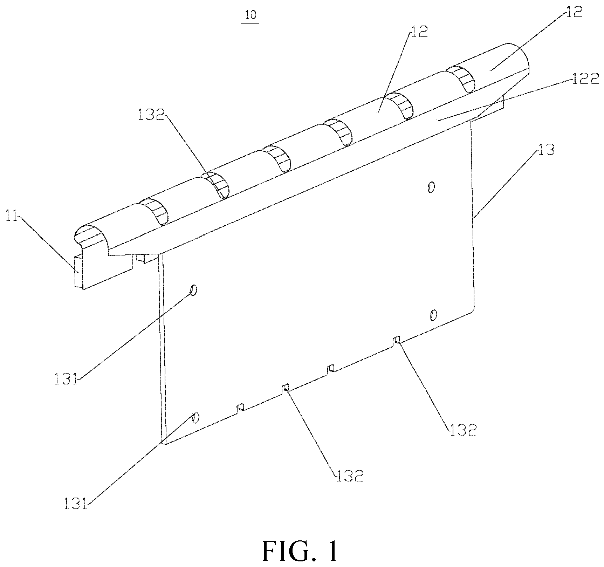

As shown in FIG. 1, the present invention discloses a battery information sampling assembly/component 10, including a battery sampling controller 13 and a flexible printed circuit board 12. The flexible printed circuit board 12 is configured to collect information about a corresponding cell, and the flexible printed circuit board 12 is directly connected with the battery sampling controller 13.

In the present invention, the battery sampling controller 13 is directly connected with the flexible printed circuit board 12, without a need to arrange/configure an additional wire harness to connect the battery sampling controller 13 to the flexible printed circuit board 12, which improves the space utilization of a battery module 20 or a battery pack 100 and indirectly improves the energy density of the battery module 20 or the battery pack 100. In addition, a problem of a failure of the battery information sampling assembly caused by wear of a wire harness as a result of external factors is avoided.

Multiple flexible printed circuit boards 12 may be provided in the battery module 20 or the battery pack 100. The multiple flexible printed circuit boards 12 are arranged/disposed at intervals. The multiple flexible printed circuit boards 12 are directly connected with the battery sampling controller 13.

The multiple flexible printed circuit boards 12 respectively collect battery information for each cell correspondingly and transmit the battery information directly to the battery sampling controller 13.

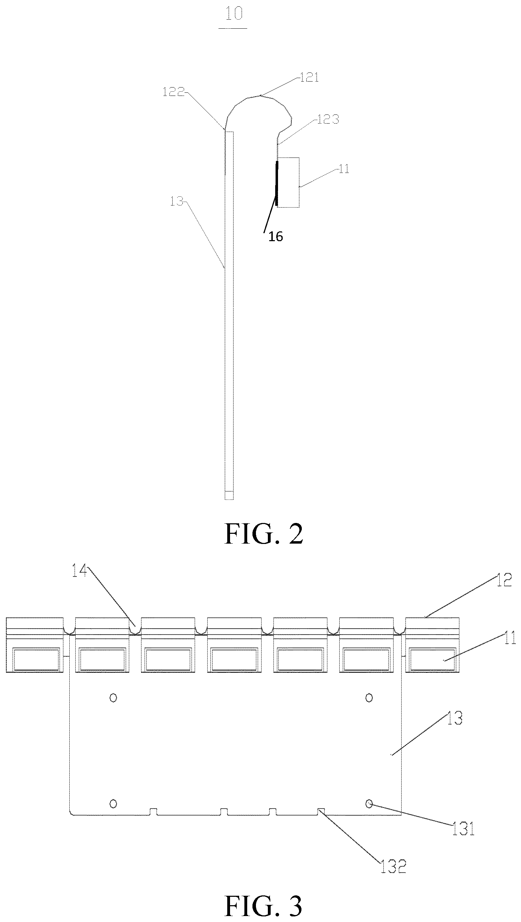

As shown in FIG. 2, according to the invention, the flexible printed circuit board 12 is overall as a structure of an upwardly arched "arch bridge". The "arch bridge" structure of the flexible printed circuit board 12 can reduce the space occupied by the battery information sampling assembly in the battery module or the battery pack 100. The flexible printed circuit board 12 includes an upwardly arched bent portion 121 with a semicircular cross-section and a first connecting portion 122 and a second connecting portion 123 arranged/disposed on two opposite sides of the bent portion 121. The flexible printed circuit board 12 is connected with the battery sampling controller 13 through the first connecting portion 122, and the flexible printed circuit board 12 is connected with the cell through the second connecting portion 123.

It may be understood that the bent portion 121 of the flexible printed circuit board 12 may be arranged/disposed in a downwardly recessed and bent shape. No specific limitations are imposed, and any modification made based on the present invention and the actual situation should be protected by the present invention. In an embodiment of the present invention, the bent portions 121 of the multiple flexible printed circuit boards 12 are arranged/disposed at intervals, and the first connecting portions 122 of the multiple flexible printed circuit boards 12 are connected as a whole. The first connecting portions 122 of the multiple flexible printed circuit boards 12 are connected as a whole and then connected to the battery sampling controller 13. The design of the connecting the first connecting portions 122 of the multiple flexible printed circuit boards 12 as a whole can improve the reliability of the connection between the flexible printed circuit boards 12 and the battery sampling controller 13.

Certainly, the structure of the flexible printed circuit board 12 in the present invention is not limited thereto. In some embodiments, the first connecting portions 122 of the multiple flexible printed circuit boards 12 may be directly connected with the battery sampling controller 13 individually.

In this embodiment of the present invention, one battery sampling controller 13 is provided, and multiple flexible printed circuit boards 12 are provided. For example, a number of the flexible printed circuit boards 12 and a number of cells are the same, and each of the flexible printed circuit board 12 collects battery information of one cell correspondingly. In this way, it can be ensured that a fault of one flexible printed circuit board 12 will not affect information collection of other cells by the battery information sampling assembly 10. In addition, the one-to-one connection between the flexible printed circuit boards 12 and the cells can ensure that in a case that some of the flexible printed circuit boards 12 fail, only the failed flexible printed circuit boards 12 need to be replaced, which is targeted and reduces the costs.

In another embodiment, the number of the flexible printed circuit boards 12 is inconsistent with the number of the cells, such that the number of the flexible printed circuit boards 12 is less than the number of the cells, that is, one flexible printed circuit board 12 collects battery information of multiple cells correspondingly. For example, one flexible printed circuit board collects battery information of two cells correspondingly. The correspondence between the flexible printed circuit boards and the cells may be properly selected based on actual requirements.

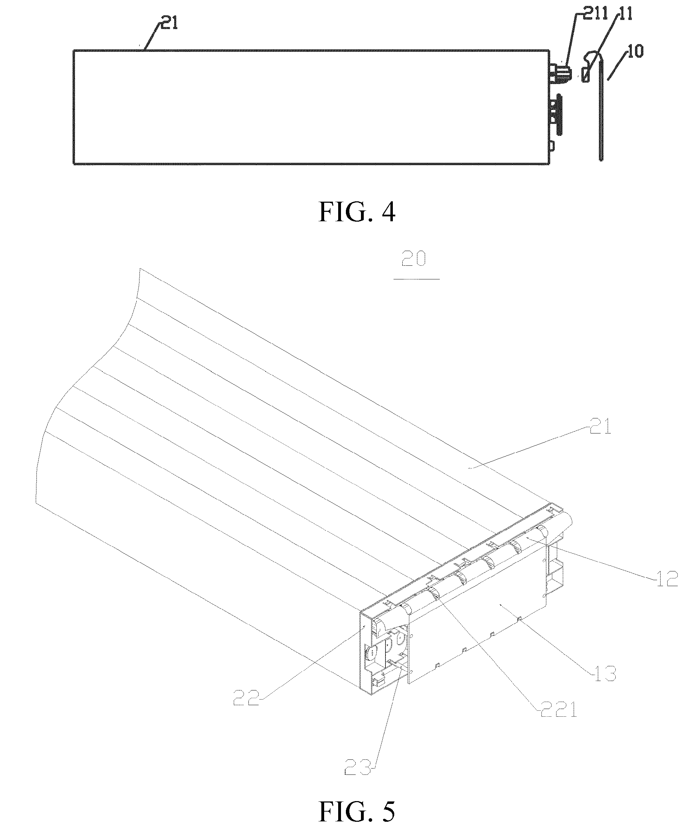

As shown in FIG. 1 and FIG. 4, in order to achieve quick connection between the battery information sampling assembly 10 and the cell 21, the battery information sampling assembly 10 further includes a plug 11 arranged/disposed on the flexible printed circuit board 12 and configured to be connected with the cell. The plug 11 is arranged on an end of the flexible printed circuit board 12. The plug 11 is inserted and assembled in a receptacle 211 on the cell 21 to achieve assembly and connection of the battery information sampling assembly 10 and the cell.

In the related art, the battery information sampling assembly is connected with the cell through welding. The process is complex and the assembly efficiency is low. The battery information sampling assembly 10 of the present invention can be quickly connected with the cell through the plug 11 arranged on the flexible printed circuit board 21, which improves the assembly efficiency of the battery information sampling assembly 10. The flexible printed circuit board 12 is connected with the plug 11 through the second connecting portion 123.

In an embodiment of the present invention, one plug 11 is correspondingly arranged/disposed on each of the flexible printed circuit boards 12, thereby realizing information collection of one cell by one flexible printed circuit board 12. In another embodiment of the present invention, multiple plugs 11 are arranged on each of the flexible printed circuit boards 12, thereby realizing information collection of multiple cells by one flexible printed circuit board 12.

Multiple plugs 11, for example, two, three, or other numbers of plugs may be arranged on each of the flexible printed circuit boards 12. A number may be properly selected based on actual requirements. The multiple plugs 11 are arranged side by side at fixed intervals on an end of one flexible printed circuit board 12.

The configuration of the multiple plugs 11 is not limited thereto, and may be adaptively adjusted according to the configuration of the cells to realize the convenient and firm insertion between the plugs 11 and the cells.

As shown in FIG. 1 and FIG. 3, in the present invention, the flexible printed circuit board 12 is welded to the battery sampling controller 13, and the plug 11 is welded to the flexible printed circuit board 12. A copper sheet on the flexible printed circuit board 12 is connected with a pin on the plug 11 through welding, and a pin led out from the battery sampling controller 13 is connected with the copper sheet on the flexible printed circuit board 12 through welding.

It may be understood that the way of connection between the flexible printed circuit board 12 and the battery sampling controller 13 and the way of connection between the plug 11 and the flexible printed circuit board 12 is not limited thereto.

The battery information sampling assembly 10 of the present invention further includes a reinforcing plate 16 arranged/disposed on a back side of the plug 11. The back side of the plug 11 is a side away from the cell. After the flexible printed circuit board 12 is welded to the plug 11, the reinforcing plate is fixedly connected with the flexible printed circuit board 12. The plug 11 is arranged on a surface (e.g., a first side) of the flexible printed circuit board 12, and the reinforcing plate is arranged on the other surface (e.g., a second side) of the flexible printed circuit board 12. The reinforcing plate is arranged on the other surface of the flexible printed circuit board 12 through adhesive. After the reinforcing plate is adhered to the flexible printed circuit board, adhesive is applied to an outer periphery of the reinforcing plate, the plug 11, and the flexible printed circuit board 12 to ensure firmer connection between the reinforcing plate, the plug 11, and the flexible printed circuit board 12.

In an embodiment of the present invention, the battery information sampling assembly 10 includes multiple reinforcing plates. One reinforcing plate is arranged on the back side of each of the plugs 11. In another embodiment of the present invention, the battery sampling assembly includes one reinforcing plate. Each of the plugs 11 is adhered and fixed to the reinforcing plate. In another embodiment of the present invention, the battery sampling assembly includes multiple reinforcing plates. Multiple plugs 11 are fixedly connected with each of the reinforcing plates.

In this embodiment of the present invention, the battery sampling controller 13 is a BIC (battery information collector) board, and a positioning hole 131 and an engagement position 132 are arranged/disposed on the BIC board. According to the battery information sampling assembly 10, a battery support 22 is positioned and assembled with the battery information sampling assembly 10 through the positioning hole 131 arranged/disposed on the battery sampling controller 13. The engagement position 132 is a groove, and a snap 221 on the battery support 22 is embedded into the engagement position 132 for engagement, so as to fix the battery information sampling assembly 10.

In this embodiment of the present invention, the battery sampling controller 13 includes four positioning holes 131. Multiple engagement positions 132 are evenly configured at fixed intervals on an upper edge and a lower edge of the battery sampling controller 13. Four engagement positions are configured on the upper edge of the battery sampling controller 13. Four engagement positions are configured on the lower edge of the battery sampling controller 13. The number of the engagement positions is not limited thereto, and may be adjusted based on actual requirements.

As shown in FIG. 4 and FIG. 5, a battery module 20 is provided. The battery module 20 includes multiple cells 21 stacked in sequence. A battery support 22 is arranged/disposed on ends of the multiple cells 21, and the ends of the multiple cells 21 extend into the battery support 22. The battery information sampling assembly is connected with receptacles 211 of the cells 21 through the plugs 11. One end of an assembly rod 23 is inserted into the positioning hole 131 of the battery sampling controller 13, and the other end extends into the battery support 22, to achieve the positioning and assembly of the battery sampling controller 13. Multiple assembly rods 23, for example, four assembly rods are provided. A snap 221 is arranged/disposed on the battery support 22. The snap 221 is embedded into the engagement position 132 on the battery sampling controller 13, to fix the battery sampling controller. A gap exists between the flexible printed circuit boards 12 of the battery information sampling assembly. The gap forms a snap avoidance position 14 on the battery support 22. A part of the snap 221 on the battery support 22 passes through the snap avoidance position 14 and fits the engagement position 132 on the upper edge of the battery sampling controller 13 to achieve the engagement. After the battery information sampling assembly 10 is assembled with the battery support 22, a protective cover (not shown in the figure) is assembled with the battery support 22 to protect the battery information sampling assembly.

The battery information sampling assembly 10 of the present invention collects battery parameter information such as a voltage and a temperature of each cell 21 through the flexible printed circuit board 12, and directly transmits the parameter information to the battery sampling controller 13. Finally, the parameter information is transmitted to a battery management system through the battery sampling controller 13, thereby realizing the monitoring of the cell.

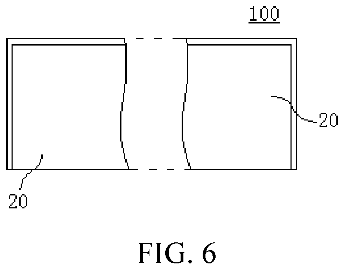

As shown in FIG. 6, a battery pack 100 includes the battery module 20 in the above embodiments.

The battery pack 100 in this embodiment of the present invention includes at least one battery module 20 using the above battery information sampling assembly10. The battery information sampling assembly 10 can realize information collection for multiple cells 21 in multiple battery modules 20 in the battery pack 100, and has a higher operational stability, which can improve the safety of the battery pack 100, and the position and space occupation of the battery information collection assembly 10 are more proper, which can improve the space utilization of the battery pack 100 and improve the energy density of the battery pack 100.

Some of the embodiments of the present invention have been shown and described. A person of ordinary skill in the art should understand that various changes, modifications, replacements, and variations may be made to the embodiments without departing from the principles of the present invention, and the scope of the present invention is defined by the appended claims.

## Claims

1. A battery information sampling assembly (10), comprising:
a battery sampling controller (13);
a flexible printed circuit board (12), wherein the flexible printed circuit board is configured to collect information of a corresponding cell (21), and the flexible printed circuit board is connected with the battery sampling controller;
a plug (11) disposed on the flexible printed circuit board, wherein the flexible printed circuit board is connected with the corresponding cell through the plug; and
a reinforcing plate (16) configured to reinforce a connection between the flexible printed circuit board and the plug, wherein the reinforcing plate is disposed on a back side of the flexible printed circuit board;
wherein the flexible printed circuit board comprises a bent portion (121), a first connecting portion (122), and a second connecting portion (123), wherein the first connecting portion and the second connecting portion are connected with the bent portion, wherein the flexible printed circuit board is connected with the battery sampling controller through the first connecting portion; and wherein the flexible printed circuit board is connected with the plug through the second connecting portion;
wherein the bent portion (121) is an upwardly arched bent portion (121) with a semi-circular cross-section and wherein the first connecting portion (122) and the second connecting portion (123) are arranged on two opposite sides of the bent portion (121).

2. The assembly according to claim 1, further comprising a plurality of flexible printed circuit boards (12) comprising the flexible printed circuit board (12), wherein
the flexible printed circuit boards are disposed at intervals, and
the flexible printed circuit boards respectively collect information of corresponding cells (21) comprising the corresponding cell (21).

3. The assembly according to claim 1 or 2, further comprising a plurality of plugs (11), wherein one of the plugs (11) is disposed on each of the flexible printed circuit boards.

4. The assembly according to claim 1, wherein
the flexible printed circuit board is welded to the battery sampling controller; and
the plug is welded to the flexible printed circuit board.

5. The assembly according to claim 1, wherein
a first side of the flexible printed circuit board is connected with the plug; and
a second side of the flexible printed circuit board is connected with the reinforcing plate.

6. The assembly according to any of claims 1 to 5, wherein
a positioning hole (131) is disposed on the battery sampling controller (13), and
the battery information sampling assembly (10) is configured to be positioned and assembled with a battery support (22) through the positioning hole (131).

7. A battery module (20), comprising:
a cell (21);
a battery support (22), arranged on the cell; and
a battery information sampling assembly (10), wherein the battery information sampling assembly is the battery information sampling assembly according to any of claims 1 to 6.

8. A battery pack (100), comprising the battery module (20) according to claim 7.

## Patentansprüche

1. Eine Batterieinformationserfassungsbaugruppe (10), umfassend:
eine Batterie-Erfassungssteuerung bzw. -Abtaststeuerung (13);
eine flexible Leiterplatte (12), wobei die flexible Leiterplatte dazu konfiguriert ist, Informationen einer entsprechenden Zelle (21) zu erfassen, und die flexible Leiterplatte mit der Batterie-Erfassungssteuerung verbunden ist;
einen Stecker (11), der auf der flexiblen Leiterplatte angeordnet ist, wobei die flexible Leiterplatte über den Stecker mit der entsprechenden Zelle verbunden ist; und
eine Verstärkungsplatte (16), die dazu konfiguriert ist, eine Verbindung zwischen der flexiblen Leiterplatte und dem Stecker zu verstärken, wobei die Verstärkungsplatte auf einer Rückseite der flexiblen Leiterplatte angeordnet ist;
wobei die flexible Leiterplatte einen gebogenen Abschnitt (121), einen ersten Verbindungsabschnitt (122) und einen zweiten Verbindungsabschnitt (123) umfasst, wobei der erste Verbindungsabschnitt und der zweite Verbindungsabschnitt mit dem gebogenen Abschnitt verbunden sind, wobei die flexible Leiterplatte über den ersten Verbindungsabschnitt mit der Batterie-Abtaststeuerung verbunden ist; und wobei die flexible Leiterplatte über den zweiten Verbindungsabschnitt mit dem Stecker verbunden ist;
wobei der gebogene Abschnitt (121) ein nach oben gewölbter gebogener Abschnitt (121) mit einem halbkreisförmigen Querschnitt ist und wobei der erste Verbindungsabschnitt (122) und der zweite Verbindungsabschnitt (123) an zwei gegenüberliegenden Seiten des gebogenen Abschnitts (121) angeordnet sind.

2. Baugruppe gemäß Anspruch 1, ferner umfassend eine Vielzahl von flexiblen Leiterplatten (12), die die flexible Leiterplatte (12) umfassen, wobei
die flexiblen Leiterplatten in Abständen angeordnet sind und
die flexiblen Leiterplatten jeweils Informationen von entsprechenden Zellen (21) erfassen, die die entsprechende Zelle (21) umfassen.

3. Baugruppe gemäß Anspruch 1 oder 2, die ferner eine Vielzahl von Steckern (11) umfasst, wobei auf jeder der flexiblen Leiterplatten einer der Stecker (11) angeordnet ist.

4. Baugruppe gemäß Anspruch 1, wobei
die flexible Leiterplatte mit der Batterie-Abtaststeuerung verschweißt ist; und
der Stecker mit der flexiblen Leiterplatte verschweißt ist.

5. Baugruppe gemäß Anspruch 1, wobei
eine erste Seite der flexiblen Leiterplatte mit dem Stecker verbunden ist; und
eine zweite Seite der flexiblen Leiterplatte mit der Verstärkungsplatte verbunden ist.

6. Baugruppe gemäß einem der Ansprüche 1 bis 5, wobei
eine Positionierungsbohrung (131) an der Batterie-Abtaststeuerung (13) angeordnet ist, und
die Batterieinformations-Erfassungsbaugruppe (10) dazu konfiguriert ist, dass sie durch die Positionierungsbohrung (131) positioniert und mit einer Batteriehalterung (22) verbunden wird.

7. Batteriemodul (20), umfassend:
eine Zelle (21);
einen Batteriehalter (22), der auf der Zelle angeordnet ist; und
eine Batterieinformationserfassungsbaugruppe (10), wobei es sich bei der Batterieinformationserfassungsbaugruppe um die Batterieinformationserfassungsbaugruppe gemäß Anspruch 1 bis 6 handelt.

8. Batteriepack (100), das das Batteriemodul (20) gemäß Anspruch 7 umfasst.

## Revendications

1. Ensemble d'échantillonnage d'informations ou de prélèvement d'informations de batterie (10), comprenant:
un contrôleur d'échantillonnage de batterie (13);
une carte de circuit imprimé flexible (12), dans lequel la carte de circuit imprimé flexible est configurée pour collecter des informations d'une cellule correspondante (21), et la carte de circuit imprimé flexible est connectée au contrôleur d'échantillonnage de batterie;
dans lequel une fiche (11) est disposée sur la carte de circuit imprimé flexible, la carte de circuit imprimé flexible étant connectée à la cellule correspondante par l'intermédiaire de la fiche; et
une plaque de renfort (16) configurée pour renforcer une connexion entre la carte de circuit imprimé flexible et la fiche, la plaque de renfort étant disposée sur une face arrière de la carte de circuit imprimé flexible;
dans lequel la carte de circuit imprimé flexible comprend une partie courbée (121), une première partie de connexion (122) et une deuxième partie de connexion (123), la première partie de connexion et la deuxième partie de connexion étant reliées à la partie courbée, la carte de circuit imprimé flexible étant reliée au contrôleur d'échantillonnage de batterie par l'intermédiaire de la première partie de connexion; et la carte de circuit imprimé flexible étant reliée à la fiche par l'intermédiaire de la deuxième partie de connexion;
dans lequel la partie courbée (121) est une partie courbée (121) formant un arc vers le haut, de section transversale semi-circulaire, et dans lequel la première partie de connexion (122) et la deuxième partie de connexion (123) sont disposées sur deux côtés opposés de la partie courbée (121).

2. L'ensemble selon la revendication 1, comprenant en outre une pluralité de cartes de circuits imprimés flexibles (12) comprenant la carte de circuits imprimés flexible (12), dans lequel
les cartes de circuits imprimés flexibles sont disposées à intervalles réguliers, et
les cartes de circuits imprimés flexibles collectent respectivement des informations provenant de cellules correspondantes (21) comprenant la cellule correspondante (21).

3. L'ensemble selon la revendication 1 ou 2, comprenant en outre une pluralité de fiches (11), dans lequel une des fiches (11) est disposée sur chacune des cartes de circuits imprimés flexibles.

4. L'ensemble selon la revendication 1, dans lequel
la carte de circuit imprimé flexible est soudée au contrôleur d'échantillonnage de batterie; et
la fiche est soudée à la carte de circuit imprimé flexible.

5. L'ensemble selon la revendication 1, dans lequel
un premier côté de la carte de circuit imprimé flexible est relié à la fiche; et
un deuxième côté de la carte de circuit imprimé flexible est relié à la plaque de renfort.

6. L'ensemble selon l'une quelconque des revendications 1 à 5, dans lequel
un trou de positionnement (131) est disposé sur le contrôleur d'échantillonnage de batterie (13), et
l'ensemble d'échantillonnage d'informations de batterie (10) est configuré pour être positionné et assemblé avec un support de batterie (22) à travers le trou de positionnement (131).

7. Module de batterie (20), comprenant:
une cellule (21);
un support de batterie (22), disposé sur la cellule; et
un ensemble de prélèvement d'informations sur la batterie (10), dans lequel l'ensemble de prélèvement d'informations sur la batterie est l'ensemble de prélèvement d'informations sur la batterie selon l'une quelconque des revendications 1 à 6.

8. Bloc de batterie (100), comprenant le module de batterie (20) selon la revendication 7.
